# EUROPÄISCHE PATENTSCHRIFT

(11) **EP 1 903 284 B1**
(45) Veröffentlichungstag und Bekanntmachung des Hinweises auf die Patenterteilung: **27.06.2018**
(21) Anmeldenummer: 06017847.2
(22) Anmeldetag: 26.08.2006
(51) Int. Cl.: F24C 7/08, H03K 17/96, H05B 3/74

(54) **Vorrichtung für ein Haushaltsgerät und Verwendung der Vorrichtung**
Device for household appliance and its use
Dispositif pour appareil ménager et son utilisation

(43) Veröffentlichungstag der Anmeldung: 26.03.2008
(60) Teilanmeldung: 18168398.8
(73) Patentinhaber: Electrolux Home Products Corporation N.V., 1130 Brussels (BE)
(72) Erfinder: Busch, Andreas, 74572 Blaufelden (DE); Meider, Claus, 74599 Wallhausen (DE); Holzinger, Jochen, 91541 Rothenburg/Tauber (DE)
(74) Vertreter: Electrolux Group Patents

(56) Entgegenhaltungen:
- EP-A- 1 662 207
- EP-A- 1 672 797
- EP-A1- 1 724 088
- DE-A1- 10 133 135
- DE-A1- 10 236 718
- DE-A1-102005 028 278
- DE-U1- 20 119 700
- DE-U1-202005 007 480
- US-B1- 6 329 646

## Beschreibung

Die Erfindung betrifft eine Vorrichtung für ein Haushaltsgerät, welche insbesondere wenigstens ein Bedienelement und wenigstens ein Anzeigeelement aufweist.

Haushaltsgeräte verschiedenster Art, beispielsweise Herde, Mikrowellengeräte, Waschmaschinen, Wäschetrockner etc., verfügen in der Regel über eine Bedieneinheit und eine Anzeigeeinheit. Mit Hilfe der Bedieneinheit kann ein Benutzer das Haushaltsgerät bedienen. Mit Hilfe der Anzeigeeinheit können einem Benutzer insbesondere Betriebszustände und Betriebsparameter des Haushaltsgerätes angezeigt werden. Die Bedieneinheit und die Anzeigeeinheit können auch miteinander zu einer Bedien- und Anzeigeeinheit kombiniert sein. Die Bedien- und Anzeigeeinheit stellt eine Komponente des Haushaltsgerätes dar.

Eine Bedien- und Anzeigeeinheit, beispielsweise für einen Herd, umfasst zumeist eine Platine mit Leiterbahnen, auf der elektrisch miteinander verbundene Standardkomponenten, beispielsweise Infrarot-Sensoren, kapazitive Sensoren, Sieben-Segmentanzeigen, LEDs (Light emitting diodes) mit Kunststoffabdeckungen etc. angeordnet sind. Eine derartige Platine einer Bedien- und Anzeigeeinheit ist in der Regel unterhalb einer Glaskeramik des Herdes angeordnet. Um eine störungsfreie Bedienung des Herdes mittels der Bedien- und Anzeigeeinheit sicherzustellen, müssen insbesondere die von einem Benutzer im Zuge der Bedienung betätigbaren kapazitiven Sensoren an die untere Oberfläche der Glaskeramik gebracht werden, was mit Hilfe von Federn, leitendem Gummi, beispielsweise der Firma EGO, oder durch Kunststoffträger bewerkstelligt werden kann. Des Weiteren ist es gängige Praxis, die Bedien- und Anzeigeeinheit, insbesondere die kapazitiven Sensoren, direkt mittels eines doppelseitigen Klebebandes an die untere Oberfläche der Glaskeramik zu kleben. Auf diese Weise befinden sich sowohl die kapazitiven Sensoren als auch die LEDs, Sieben-Segmentanzeigen oder andere optische Anzeigen, dicht oder direkt unter der Glaskeramik und ermöglichen eine Bedienung des Haushaltsgerätes sowie ein Ablesen von Betriebszuständen und Betriebsparametern des Haushaltsgerätes.

Als nachteilig hat sich der verhältnismäßig aufwändige Aufbau derartiger Bedien- und Anzeigeeinheiten, insbesondere die Anordnung von Bedien- und Anzeigeelementen nebeneinander, erwiesen.

In der DE 201 19 700 U1 ist eine Sensorvorrichtung zur Erzeugung eines Schaltsignals beschrieben. Das Schaltsignal wird durch Annäherung und/oder Berührung eines kapazitiven Sensorelements mit dem Finger ausgelöst. Das Sensorelement ist an der Oberseite eines Trägerelements angeordnet. Die Oberseite mit dem Sensorelement ist von einer Blende aus einem durchsichtigen Material abgedeckt. An der Unterseite des Trägerelements befindet sich eine Leiterplatte mit einem Leuchtmittel. Das Leuchtmittel ist innerhalb einer Durchgangsöffnung des Trägerelements angeordnet, so dass das Licht durch die Blende nach Außen treten kann.

Die EP 1 724 088 A1 zeigt und beschreibt ein Anzeige- und Bedienungspaneel für Haushaltsgeräte mit einer verformten Blendenfront, in der Anzeige- und Bedienungsbereiche angeordnet sind. Ein Blendenkörper und eine Blendenfront bilden zusammen eine Trägerstruktur, hinter welcher Bedien- und Anzeigeelemente, zum Teil in entsprechenden Aussparungen, angeordnet sind.

Der Erfindung liegt die Aufgabe zugrunde, eine Vorrichtung der eingangs genannten Art möglichst kompakt auszubilden.

Nach der Erfindung wird diese Aufgabe gelöst durch eine Vorrichtung für ein Haushaltsgerät mit einem eine Oberseite und eine Unterseite umfassenden Trägerelement, einer wenigstens ein Bedienelement aufweisenden Bedieneinrichtung und einer wenigstens ein Anzeigeelement aufweisenden Anzeigeeinrichtung, wobei das Trägerelement auf seiner Unterseite wenigstens eine erste Aussparung aufweist, die als erste Vertiefung auf der Unterseite des Trägerelementes ausgebildet ist, und wobei die Bedieneinrichtung auf der Oberseite des Trägerelementes und die Anzeigeeinrichtung zumindest teilweise in der ersten Aussparung auf der Unterseite des Trägerelementes angeordnet ist. Zum Erhalt der ersten Vertiefung auf der Unterseite des Trägerelementes eine Durchgangsöffnung mit einem im Wesentlichen lichtdurchlässigen Material des Trägerelementes verschlossen und/oder zumindest teilweise ausgefüllt ist. Dabei erfolgt demnach eine Trennung von Bedieneinrichtung und Anzeigeeinrichtung, wobei die Bedieneinrichtung an der Oberseite des Trägerelementes und die Anzeigeeinrichtung auf der Unterseite des Trägerelementes angeordnet sind und die Durchgangsöffnung mit dem lichtdurchlässigen Material verschlossen und/oder zumindest teilweise ausgefüllt ist.

Erfindungsgemäß ist vorgesehen, dass die Durchgangsöffnung zur Bildung der ersten Vertiefung derart mit dem im wesentlichen lichtdurchlässigen Material verschlossen und/oder zumindest teilweise ausgefüllt ist, dass sich auf der Oberseite des Trägerelementes im Bereich der Durchgangsöffnung eine im Wesentlichen plane Teiloberfläche und dass sich auf der Unterseite des Trägerelementes eine erste Aussparung in Form der ersten Vertiefung ergibt. Weist also das Trägerelement mehrere derartige Durchgangsöffnungen auf, welche auf der Oberseite des Trägerelementes mit dem zweiten Material verschlossen und/oder zumindest teilweise ausgefüllt sind, so ergeben sich mehrere erste Vertiefungen auf der Unterseite des Trägerelementes, in denen, wie bereits erwähnt, jeweils ein Anzeigeelement der Anzeigeeinrichtung angeordnet werden kann. Dadurch, dass das zweite Material des Trägerelementes im Wesentlichen lichtdurchlässig ist, kann demnach ein von einem Anzeigeelement ausgehendes Licht durch das Trägerelement hindurchtreten.

Die Anzeigeeinrichtung kann in raumsparender, vorteilhafter Weise zumindest teilweise in einer ersten Aussparung auf der Unterseite des Trägerelementes angeordnet werden. In der Regel weist das Trägerelement mehrere erste Aussparungen auf, in denen bevorzugt jeweils wenigstens ein Anzeigeelement der Anzeigeeinrichtung aufgenommen bzw. angeordnet werden kann. Die Struktur des Trägerelementes auf der Unterseite ist demnach bevorzugt an die Anzeigeeinrichtung, insbesondere an die Anordnung von Anzeigeelementen auf der Anzeigeeinrichtung, angepasst, so dass bevorzugt jedes Anzeigeelement der Anzeigeeinrichtung bei Anordnung der Anzeigeeinrichtung an der Unterseite des Trägerelementes in einer ersten Aussparung des Trägerelementes angeordnet wird. Auf diese Weise wird ein einfacher und kompakter Aufbau der Vorrichtung erreicht.

Nach einer Variante der Erfindung weist das Trägerelement auch auf seiner Oberseite wenigstens eine Aussparung auf, welche als zweite Aussparung zur Unterscheidung von der bzw. den ersten Aussparungen auf der Unterseite des Trägerelementes bezeichnet wird. Die zweite Aussparung ist bevorzugt als zweite Vertiefung ausgeführt. Die Bedieneinrichtung ist dabei zumindest teilweise in der zweiten Aussparung auf der Oberseite des Trägerelementes angeordnet. Dadurch ergibt sich nochmals eine Verbesserung des kompakten Aufbaus der Vorrichtung, so dass die Vorrichtung in ihrer Tiefe nur gering aufbaut.

Eine Variante der Erfindung sieht vor, dass das Trägerelement ein im Wesentlichen lichtundurchlässiges und/oder temperaturbeständiges Material aufweist. Bevorzugt ist das Trägerelement zumindest teilweise aus diesem lichtundurchlässigen und/oder temperaturbeständigen Material aufgebaut. Dadurch kann das Trägerelement eine Doppelfunktion erfüllen, da es einerseits unter Berücksichtigung der an der Unterseite des Trägerelementes angeordneten Anzeigeeinrichtung für diese eine Art Lichtmaske ist. Zugleich dient das Trägerelement, wie bereits der Bezeichnung "Trägerelement" zu entnehmen ist, als Träger der Bedieneinrichtung als auch der Anzeigeeinrichtung.

Eine Ausführungsform der Erfindung sieht vor, dass das im Wesentlichen lichtdurchlässige Material des Trägerelementes ein zweites Material des Trägerelementes ist.

Das Trägerelement weist wenigstens eine Durchgangsöffnung oder erste Vertiefung, in der Regel mehrere Durchgangsöffnungen oder erste Vertiefungen auf, in denen, wie bereits erwähnt, bevorzugt jeweils wenigstens ein Anzeigeelement angeordnet werden kann, so dass das von einem Anzeigeelement ausgehende Licht sei es durch die Durchgangsöffnung oder die mit dem lichtdurchlässigen Material versehene erste Vertiefung durch das Trägerelement hindurchtreten kann.

Nach Varianten der Erfindung handelt es sich bei dem ersten und/oder bei dem zweiten Material jeweils um einen Kunststoff. Bevorzugt handelt es sich bei dem zweiten Material um ein lichtzerstreuendes Material oder um einen lichtzerstreuenden Kunststoff oder explizit um ein Epoxydharz. Durch das lichtzerstreuende Material ergibt sich eine gleichmäßige Ausleuchtung der ersten Vertiefung, wenn man das Trägerelement im Bereich der jeweiligen ersten Aussparung bzw. ersten Vertiefung von der Oberseite her betrachtet.

Nach einer Variante der Erfindung weist die Bedieneinrichtung eine Platine, eine Folie oder einen Bedienelementträger auf, welche jeweils wenigstens ein Bedienelement umfassen. Die zweite Aussparung auf der Oberseite des Trägerelementes ist bevorzugt an die Form der Platine, der Folie oder des Bedienelementträgers angepasst, so dass die Platine, die Folie oder der Bedienelementträger bevorzugt passgenau zumindest teilweise in der zweiten Aussparung auf der Oberseite des Trägerelementes aufgenommen werden kann. Die Bedieneinrichtung ist in der Regel dabei derart ausgestaltet, dass sie an den Stellen Ausschnitte aufweist, an denen Licht von Anzeigeelementen der Anzeigeeinrichtung das Trägerelement im Bereich der ersten Aussparungen durchdringt bzw. durchdringen soll. Die Bedieneinrichtung überdeckt also die den ersten Aussparungen zugeordneten Oberflächen auf der Oberseite des Trägerelementes nicht.

Die Platine oder die Folie oder der Bedienelementträger weist wenigstens eine Leiterbahn und/oder wenigstens eine Kupferfläche auf. In der Regel weist die Platine oder die Folie oder der Bedienelementträger mehrere Leiterbahnen oder Kupferflächen auf. Als Bedienelement umfasst die Bedieneinrichtung wenigstens einen Sensor, beispielsweise einen kapazitiven Sensor oder kapazitiven Tastsensor, durch dessen Betätigung Bedieneingaben möglich sind.

Nach einer Ausführungsform der Erfindung weist die Anzeigeeinrichtung eine wenigstens ein Anzeigeelement umfassende Platine oder einen wenigstens ein Anzeigeelement umfassenden Anzeigeelementträger auf. Die Platine oder der Anzeigeelementträger weist wenigstens eine Leiterbahn, in der Regel mehrere Leiterbahnen, auf. Bei den Anzeigeelementen der Anzeigeeinrichtung handelt es sich bevorzugt um Leuchtelemente, beispielsweise LEDs oder Sieben-Segmentanzeigen, welche ebenfalls aus LEDs aufgebaut sein können.

Die Anzeigeeinrichtung und die Bedieneinrichtung sind in der Regel elektrisch miteinander verbunden, wobei die elektrische Verbindung beispielsweise mittels eines Folienleiters oder mittels wenigstens einer Kontaktbuchse und wenigstens einem Kontaktstift erfolgen kann.

Nach einer Ausführungsform der Erfindung bilden das Trägerelement, die Bedieneinrichtung und die Anzeigeeinrichtung eine Einheit, wobei das Trägerelement, die Bedieneinrichtung und die Anzeigeeinrichtung fest, bevorzugt aber lösbar, miteinander verbunden sind. Die Verbindung kann allerdings auch nichtlösbar ausgeführt sein. Bevorzugt erfolgt die Verbindung von Trägerelement, Bedieneinrichtung und Anzeigeeinrichtung mittels Rastverbindung, Ultraschallverschweißung und/oder Verkleben.

Nach einer Variante der Erfindung ist auf der Oberseite des Trägerelementes und/oder der Bedieneinrichtung eine wenigstens ein Symbol aufweisende, zumindest teilweise lichtdurchlässige Folie angeordnet. Bei den Symbolen der Folie handelt es sich um Bediensymbole und/oder Anzeigesymbole, wobei ein Anzeigesymbol insbesondere oberhalb einer ersten Aussparung bzw. oberhalb einer Durchgangsöffnung oder ersten Vertiefung angeordnet ist.

Es besteht aber auch die Möglichkeit, die Oberfläche der Oberseite des Trägerelementes mit wenigstens einem Symbol zu bedrucken, was beispielsweise mittels Siebdruck oder Tampondruck erfolgen kann. Alternativ kann die Oberfläche der Oberseite des Trägerelementes zumindest teilweise beschichtet sein, wobei in die Beschichtung wenigstens ein Symbol eingearbeitet ist. Bei der Beschichtung kann es sich beispielsweise um einen lichtundurchlässigen Lack handeln, der zur Erzeugung des Symbols teilweise entfernt wird, wozu beispielsweise ein Laser verwendet werden kann.

Nach einer Variante der Erfindung ist ein Anzeigeelement der Anzeigeeinrichtung in einer ersten Vertiefung des Trägerelementes angeordnet, wobei der in Richtung auf die Oberseite des Trägerelementes gesehene Boden der ersten Vertiefung ein im Wesentlichen lichtdurchlässiges Material aufweist, wobei über dem Boden auf der Oberfläche der Oberseite des Trägerelementes ein Symbol angeordnet ist. Wenn also eine Durchgangsöffnung des Trägerelementes mit einem zweiten, im Wesentlichen lichtdurchlässigen Material verschlossen ist, kann auf dem Boden dieser ersten Vertiefung auf der Oberfläche der Oberseite des Trägerelementes ein Symbol aufgedruckt oder in eine Beschichtung eingebracht oder eine Folie mit einem Symbol angeordnet werden. Wird eine Folie mit Symbolen verwendet, ist es nicht unbedingt erforderlich, die Durchgangsöffnung mit einem lichtdurchlässigen Material zu versehen, da in diesem Fall das Symbol nicht auf die Oberfläche der Oberseite des Trägerelementes aufgedruckt bzw. in eine Beschichtung der Oberfläche eingebracht wird, sondern auf der Folie vorhanden ist.

Bei der Vorrichtung handelt es sich bevorzugt um eine Bedien- und Anzeigeeinheit, welche bevorzugt für einen Herd vorgesehen und unter einer Glaskeramik eines Herdes angeordnet ist.

Die Vorrichtung wird also bevorzugt als Bedien- und Anzeigeeinheit für einen Herd verwendet. Die Vorrichtung kann jedoch auf für andere Haushaltsgeräte verwendet werden.

Ein Ausführungsbeispiel der Erfindung ist in den beigefügten schematischen Zeichnungen dargestellt. Es zeigen:
- FIG 1: in einer perspektivischen, auseinandergezogenen Darstellung eine Bedien- und Anzeigeeinheit für ein Haushaltsgerät mit einer Bedieneinrichtung, einem Trägerelement und einer Anzeigeeinrichtung;

- FIG 2: in einer geschnittenen Darstellung die Anordnung einer Bedien- und Anzeigeeinheit unter einer Glaskeramik eines Herdes und
- FIG 3: eine Draufsicht auf eine Bedien- und Anzeigeeinheit.

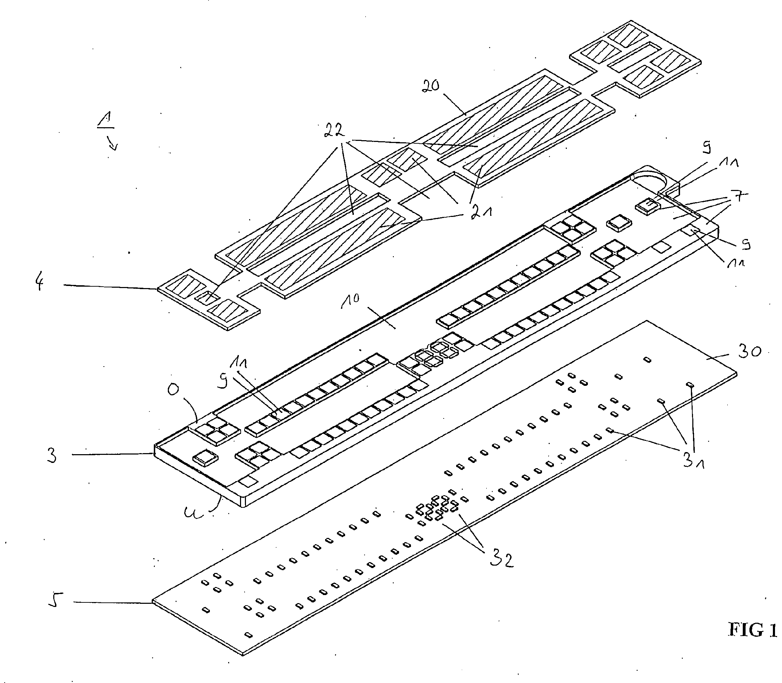

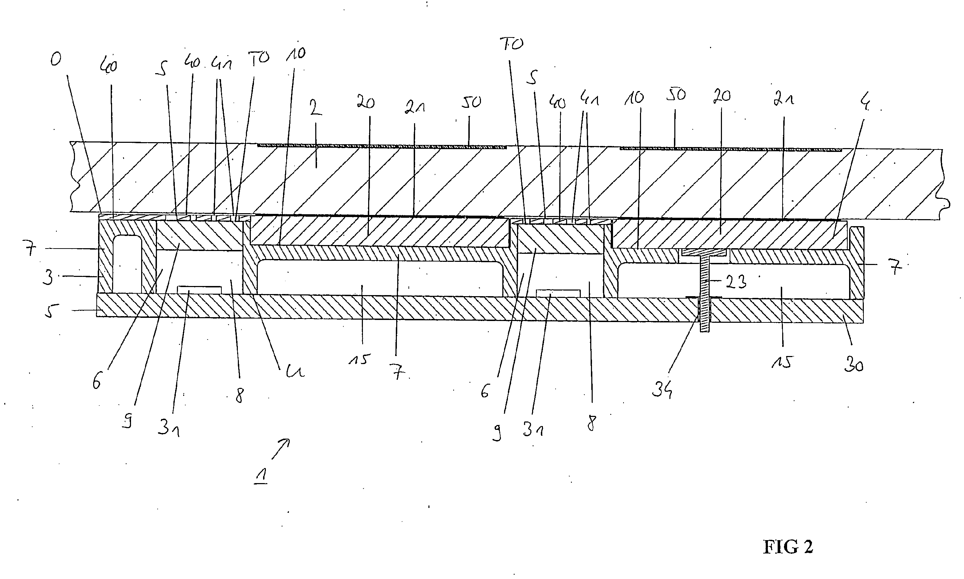

In FIG 1 ist in einer perspektivischen, auseinandergezogenen Darstellung eine erfindungsgemäße Vorrichtung für ein Haushaltsgerät in Form einer Bedien- und Anzeigeeinheit 1 gezeigt. Bei der Bedien- und Anzeigeeinheit 1 handelt es sich im Falle des vorliegenden Ausführungsbeispiels um eine Bedien- und Anzeigeeinheit 1 für einen Herd, wobei die Bedien- und Anzeigeeinheit 1, wie der FIG 2 zu entnehmen ist, zur Anordnung unterhalb einer Glaskeramik 2 eines Herdes vorgesehen ist.

Wie der FIG 1 entnommen werden kann, weist die Bedien- und Anzeigeeinheit 1 ein Trägerelement 3, eine Bedieneinrichtung 4 und eine Anzeigeeinrichtung 5 auf.

Das Trägerelement 3 ist im Falle des vorliegenden Ausführungsbeispiels ein Kunststoffformteil mit einer Oberseite O und einer Unterseite U. Wie insbesondere der FIG 2 zu entnehmen ist, weist das Trägerelement 3 auf der Unterseite U mehrere Ausnehmungen 15 und insbesondere mehrere erste Aussparungen bzw. erste Vertiefungen 6 auf. Das Trägerelement 3 ist im Falle des vorliegenden Ausführungsbeispiels aus zwei verschiedenen Kunststoffen ausgebildet, wobei der erste Kunststoff mit dem Bezugszeichen 7 versehen ist. Bei dem ersten Kunststoff 7 handelt es sich um einen, bevorzugt im Wesentlichen lichtundurchlässigen und/oder temperaturbeständigen Kunststoff. Insbesondere ist die Stärke bzw. die Dicke der Materialschicht des Kunststoffes derart gewählt, dass dieser lichtundurchlässig ist.

Die ersten Aussparungen bzw. ersten Vertiefungen 6 in dem Trägerelement 3 sind im Falle des vorliegenden Ausführungsbeispiels derart erzeugt, dass Durchgangsöffnungen 8 in dem ersten Kunststoff 7 des Trägerelementes 3 mit einem zweiten Kunststoff 9 einseitig verschlossen und im Falle des vorliegenden Ausführungsbeispiels zumindest teilweise ausgefüllt sind. Es wird also deutlich, dass das Trägerelement 3 im Falle des vorliegenden Ausführungsbeispiels aus einem ersten Kunststoff 7 und einem zweiten Kunststoff 9 ausgebildet ist, wobei Durchgangsöffnungen 8 im ersten Kunststoff 7 mittels eines zweiten Kunststoffes 9, welcher im Wesentlichen lichtdurchlässig ist, verschlossen sind. Der zweite Kunststoff 9 ist dabei jeweils derart in einer Durchgangsöffnung 8 angeordnet, dass sich auf der Oberseite O des Trägerelementes 3 im Bereich der Durchgangsöffnung 8 eine im Wesentlichen plane Teiloberfläche TO und auf der Unterseite U des Trägerelementes eine ersten Aussparung bzw. erste Vertiefung 6 ergeben. Bei dem zweiten Kunststoff 9 handelt es sich im Übrigen bevorzugt um einen lichtzerstreuenden Kunststoff, beispielsweise um ein Epoxydharz. Der zweite Kunststoff 9 ist insbesondere hinsichtlich seiner Schichtdicke bzw. Materialstärke derart in einer Durchgangsöffnung 8 ausgeführt, dass Licht in für eine Anzeige ausreichender Weise durch den zweiten Kunststoff 9 bzw. das Trägerelement 3 im Bereich der Durchgangsöffnung 8 bzw. der ersten Vertiefung 6 dringen kann.

Das Trägerelement 3 muss aber im Unterschied zu dem vorliegenden Ausführungsbeispiel nicht notwendigerweise aus zwei Kunststoffmaterialien ausgebildet sein. Vielmehr kann das Trägerelement 3 auch aus einem anderen, im Wesentlichen lichtundurchlässigen und/oder temperaturbeständigen ersten Material, beispielsweise einem Metall, ausgebildet sein. Auch bei dem zweiten Material muss es sich nicht notwendigerweise um einen Kunststoff handeln, vielmehr ist auch ein anderes, im Wesentlichen lichtdurchlässiges Material geeignet eine Durchgangsöffnung 8 einseitig zu verschließen und eine erste Vertiefung 6 auszubilden.

Bei dem Trägerelement 3 des vorliegenden Ausführungsbeispiels handelt es sich im Übrigen um ein Spritzgussteil, welches in einer entsprechenden Spritzgussmaschine bereits mit den zwei Kunststoffen hergestellt werden kann. Alternativ besteht die Möglichkeit, das Trägerelement 3 zunächst hinsichtlich des ersten Kunststoffmaterials zu erzeugen und die Durchgangsöffnungen 8 anschließend teilweise, beispielsweise mit einem Epoxydharz auszugießen, um die in FIG 2 dargestellten ersten Vertiefungen 6 zu erhalten.

In FIG 1 ist nochmals der Aufbau des Trägerelementes 3 hinsichtlich der zwei Kunststoffmaterialien erkennbar. Demnach ist das Trägerelement 3 im Falle des vorliegenden Ausführungsbeispiels im Wesentlichen aus dem lichtundurchlässigen Kunststoff 7 ausgebildet, welcher als eine Art Lichtmaske dient. Nur in den Bereichen, in denen die Durchgangsöffnungen 8 verschlossen wurden, liegt der lichtdurchlässige Kunststoff 9 vor, der in FIG 1 im Wesentlichen mit quadratischen Feldern 11 dargestellt ist, bei denen es sich quasi um Lichtfenster 11 handelt. Die Lichtfenster 11 müssen im Übrigen nicht notwendigerweise quadratisch sein, sondern können auch rund, oval, rechteckig sein oder eine andere Form aufweisen.

Wie insbesondere der FIG 1 entnommen werden kann, weist das Trägerelement 3 im Falle des vorliegenden Ausführungsbeispiels eine zweite Aussparung 10 in Form einer zweiten Vertiefung 10 auf seiner Oberseite O auf, welche derart ausgestaltet ist, dass sie die noch zu beschreibende Bedieneinrichtung 4 möglichst gut bzw. passgenau aufnehmen kann. Die Aufnahme der Bedieneinrichtung 4 in der zweiten Aussparung 10 auf der Oberseite O des Trägerelementes 3 ist in FIG 2 dargestellt. Die Bedieneinrichtung 4 ist vorliegend passgenau in der zweite Aussparung 10 des Trägerelementes 3 angeordnet. Im Falle des vorliegenden Ausführungsbeispiels weist die Bedieneinrichtung 4 eine Platine 20 auf, die mit Sensorflächen 21 versehen ist. Eine solche Sensorfläche 21 kann mit Kupfer versehen sein und/oder wenigstens einen kapazitiven Sensor, insbesondere einen kapazitiven Tastsensor als Bedienelement aufweisen. Ein Tastsensor kann beispielsweise ein Schalter oder eine Schieberegler sein. Die Tastsensoren können also verschiedenartig ausgeführt sein und sich funktionell unterscheiden. Die Platine 20 weist insbesondere dort Ausschnitte 22 auf, wo die den lichtdurchlässigen Kunststoff 9 aufweisenden Lichtfenster 11 des Trägerelementes 3 vorhanden sind, da dort in noch zu beschreibender Weise Licht aus der Bedien- und Anzeigeeinheit 1 austreten soll.

Die Bedieneinrichtung muss im Übrigen nicht notwendigerweise eine Platine 20 aufweisen. Vielmehr kann die Bedieneinrichtung auch eine wenigstens ein Bedienelement umfassende Folie aufweisen, die auf der Oberfläche O des Trägerelementes 3 angeordnet ist bzw. angeordnet werden kann. In diesem Fall ist es nicht unbedingt notwendig, auf der Oberseite O des Trägerelementes 3 eine zweite Aussparung 10 vorzusehen. Vielmehr könnte die Folie in einfacher Weise auf der Oberfläche der Oberseite O des Trägerelementes 3 angeordnet, z. B. aufgeklebt werden. Da aber selbst eine Folie eine gewisse Stärke aufweist, kann es dennoch nützlich sein, eine zweite Aussparung 10, wenn auch mit geringerer Tiefe, auf der Oberseite O des Trägerelementes 3 vorzusehen. Die Folie kann im Übrigen in gleicher Weise mit Sensoren bzw. Sensorfeldern versehen sein. Im Übrigen kann die Bedieneinrichtung, insbesondere die Platine 20 oder die Folie in nicht dargestellter Weise Leiterbahnen aufweisen.

Die mit dem Bezugszeichen 5 versehene Anzeigeeinrichtung weist im Falle des vorliegenden Ausführungsbeispiels eine Platine 30 auf, auf der vorliegend eine Vielzahl von Leuchtelementen, im Falle des vorliegenden Ausführungsbeispiels LEDs 31, angeordnet sind. Etwa in der Mitte der Platine 30 bilden LEDs 31 dabei zwei Sieben-Segmentanzeigen 32. Die LEDs 31 sind im Falle des vorliegenden Ausführungsbeispiels derart auf der Platine 30 angeordnet, dass sie bei der Anordnung der Platine 30 an der Unterseite U des Trägerelementes 3 bevorzugt in einer erste Vertiefung 6 angeordnet werden. Die Anordnung der ersten Vertiefungen 6 des Trägerelementes 3 und die Anordnung der LEDs 31 auf der Platine 30 sind derart aufeinander abgestimmt, dass bevorzugt jeweils eine LED 31 in einer ersten Vertiefung 6 angeordnet wird, so dass von einer LED 31 ausgehendes Licht durch den lichtzerstreuenden Kunststoff 9 auf der Oberseite aus der Bedien- und Anzeigeeinheit 1 austreten kann. Auf der Unterseite der Platine 30 können im Übrigen in in den FIG nicht dargestellter Weise weitere elektrotechnische Bauelemente, insbesondere weitere elektronische Bauelemente, angeordnet sein, welche über nichtgezeigte Leiterbahnen mit den LEDs 31, beispielsweise über Durchkontaktierungen, verbunden sind.

Die Bedieneinrichtung 4 und die Anzeigeeinrichtung 5 sind elektrisch miteinander verbunden, was beispielsweise über Folienleiter, Kabel, insbesondere Flexkabel, über Stiftleisten, welche miteinander verlötet, verpresst oder versteckt sind, bewerkstelligt sein kann. Im Falle des vorliegenden Ausführungsbeispiels ist an der Unterseite der Platine 20 der Bedieneinrichtung 4 ein Kontaktstift 23 angelötet, welcher mit einer Buchse 34 der Platine 30, bei der es sich um eine Kupferbuchse handelt, zur elektrischen Kontaktierung der Bedieneinrichtung 4 und der Anzeigeinrichtung 5 miteinander zusammenwirkt. Die Bedien- und Anzeigeeinheit 1 kann mehrere derartige Kontaktstifte und Kontaktbuchsen aufweisen.

Wie der FIG 2 zu entnehmen ist, ist im Falle des vorliegenden Ausführungsbeispiels die Oberseite O des Trägerelementes 3, insbesondere die Oberfläche der Oberseite O des Trägerelementes 3 außerhalb der zweiten Aussparung 10 mit einem lichtundurchlässigen Lack 40 beschichtet. Oberhalb einer ersten Vertiefung 6, also über dem Boden einer ersten Vertiefung 6, ist auf der Oberfläche der Oberseite O des Trägerelementes 3 ein Symbol S eingearbeitet, was in FIG 2 durch Entfernung des Lackes 40 veranschaulicht ist. Im Falle des vorliegenden Ausführungsbeispiels sind die Lücken 41 in dem Lack 40 mit Hilfe eines Lasers eingebracht worden. Auf diese Weise kann jeweils oberhalb einer ersten Vertiefung 6 auf der Oberfläche der Oberseite O des Trägerelementes 3 in entsprechender Weise ein gewünschtes Symbol erzeugt werden, welches ein Bediener bei Aufleuchten einer LED 31 erkennen kann. Auf diese Weise können also die Lichtfenster 11 des Trägerelementes 3 jeweils mit einem entsprechenden Anzeigesymbol zur Anzeige unter anderem von Betriebszuständen und Betriebsparametern des Haushaltsgerätes versehen werden.

Derartige Symbole müssen aber nicht notwendigerweise aus einer Beschichtung 40 herausgearbeitet werden. Vielmehr besteht auch die Möglichkeit die Oberseite eines Bodens einer ersten Vertiefung 6, also die Oberfläche der Oberseite O des Trägerelementes 3 mit einem Symbol zu bedrucken. Hierfür kann beispielsweise Siebdruck oder Tampondruck verwendet werden. Auch auf diese Weise lassen sich ausleuchtbare Symbole oberhalb einer ersten Vertiefung 6 erhalten.

Alternativ kann auch in in den FIG nicht dargestellter Weise auf der Oberseite O des Trägerelementes 3 eine wenigstens ein Symbol, in der Regel mehrere Symbole, aufweisende Folie angeordnet, z. B. aufgeklebt werden, wobei die Folie derart auf dem Trägerelement 3 angeordnet wird, dass sich die vorgesehenen Symbole jeweils über einem Lichtfenster 11 befinden. Bevorzugt ist die Folie nur im Bereich der Symbole lichtdurchlässig. Die Symbole können dabei beispielsweise aus der Folie ausgestanzt sein oder die Folie weist zur Ausbildung der Symbole beispielsweise Schwärzungen auf, so dass bei Beleuchtung der Folie die Symbole zu erkennen sind. Bei Verwendung einer derartigen Symbole aufweisenden Folie, kann im Übrigen ggf. in Abweichung von dem bisher beschriebenen Ausführungsbeispiel, auf den zweiten Kunststoff 9, welcher die Durchgangsöffnungen 8 verschließt, verzichtet werden, da in diesem Fall keine Beschichtung bzw. Bedruckung des zweiten Kunststoffs 9 vorgesehen bzw. erfolgt ist. Der zweite Kunststoff 9 kann jedoch auch dann vorgesehen sein, wenn damit bewirkt werden soll, dass das von einer LED 31 ausgehende Licht diffus gestreut werden soll, um damit das Symbol besser auszuleuchten. Der zweite Kunststoff hat also auch die Funktion eines Diffusors.

In in den FIG nicht dargestellter Weise sind das Trägerelement 3, die Bedieneinrichtung 4 und die Anzeigeeinrichtung 5 derart miteinander verbunden, dass sie eine Einheit bilden. Die Verbindung kann dabei eine lösbare, aber auch eine nichtlösbare Verbindung sein. Als lösbare Verbindung ist beispielsweise eine Rastverbindung mit Rasthaken oder eine Schraubenverbindung möglich. Eine nichtlösbare Verbindung stellt das Ultraschallverschweißen sowie das Verkleben des Trägerelementes 3, der Bedieneinrichtung 4 und der Anzeigeeinrichtung 5 dar.

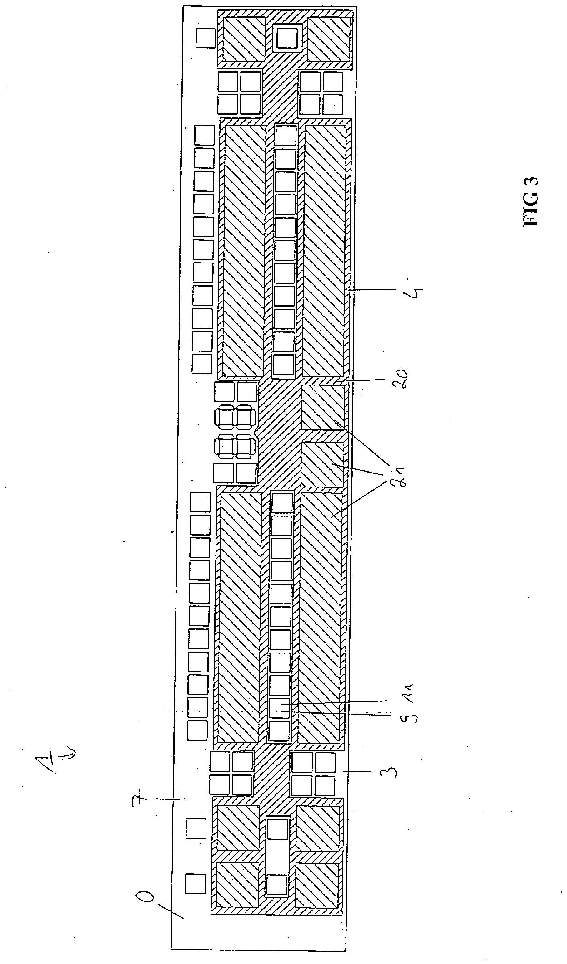

Die FIG 3 zeigt ergänzend nochmals eine Ansicht der Bedien- und Anzeigeeinheit 1 von oben, wobei die den Lichtfeldern 11 zugeordneten Symbole nicht gezeigt sind.

Wie bereits erwähnt ist die Bedien- und Anzeigeeinheit 1 im Falle des vorliegenden Ausführungsbeispiels für einen in seiner Gesamtheit nicht dargestellten Herd vorgesehen, wobei, wie aus FIG 2 zu erkennen ist, die Bedien- und Anzeigeeinheit 1 direkt unterhalb einer Glaskeramik 2 des Herdes angeordnet ist. Die Bedien- und Anzeigeeinheit 1 kann unter die Glaskeramik 2 gepresst oder unter die Glaskeramik 2 geklebt sein. Die Anordnung der Bedien- und Anzeigeeinheit 1 nur unter Druck an der Glaskeramik 2 hat Vorteile bei einem eventuell erforderlichen Austausch der Bedien- und Anzeigeeinheit 1 oder einer Komponente der Bedien- und Anzeigeeinheit 1. Bei einer defekten Komponente oder einer defekten Bedien- und Anzeigeeinheit 1 an sich muss die Glaskeramik nicht mit ausgetauscht werden. Vielmehr kann nur die defekte Komponente der Bedien- und Anzeigeeinheit 1 oder die Bedien- und Anzeigeeinheit 1 an sich ausgetauscht werden. Entsprechendes gilt bei einer defekten Glaskeramik. In diesem Fall kann nur die Glaskeramik ausgetauscht werden.

Auf der Oberseite der Glaskeramik 2 befinden sich Bedruckungen 50, die den Benutzer auf die Bedienelemente der Bedien- und Anzeigeeinheit 1 hinweisen. Der Benutzer kann demnach beispielsweise mittels der kapazitiven Sensoren den Herd bedienen, wobei je nach Eingaben des Bedieners und Betriebszustandes des Herdes unterschiedliche LEDs 31 aufleuchten und Betriebszustände über die erwähnten Symbole S sowie die Sieben-Segmentanzeigen 32 dem Bediener anzeigen.

Die Bedien- und Anzeigeeinheit 1 ist im Übrigen in nicht dargestellter Weise mit einer Steuerung des Herdes verbunden, welche die Bedieneingaben des Bedieners entsprechend auswertet, verarbeitet und unter anderem für die Ansteuerung der Anzeigeelemente der Anzeigeeinrichtung 5 sorgt. Die Bedien- und Anzeigeeinheit 1 kann aber auch selbst steuernde Bauelemente aufweisen.

Die Bedien- und Anzeigeeinrichtung wurde vorstehend am Beispiel einer Bedien- und Anzeigeeinrichtung 1 für einen Herd beschrieben. Die Bedien- und Anzeigeeinrichtung ist jedoch auch bei anderen Haushaltsgeräten einsetzbar. Beispielsweise kann auch eine Waschmaschine oder ein Trockner mit einer derartigen Bedieneinrichtung versehen sein.

Die erfindungsgemäße Vorrichtung bzw. die erfindungsgemäße Bedien- und Anzeigeeinheit zeichnet sich durch einen einfachen, modularen, robusten und kompakten Aufbau aus, wodurch die Bedien- und Anzeigeeinheit auch einfach zu montieren ist.

### Bezugszeichenliste

- 1: Bedien- und Anzeigeeinheit
- 2: Glaskeramik
- 3: Trägerelement
- 4: Bedieneinrichtung
- 5: Anzeigeeinrichtung
- 6: erste Aussparung bzw. erste Vertiefung
- 7: erster Kunststoff
- 8: Durchgangsöffnung
- 9: zweiter Kunststoff
- 10: zweite Aussparung bzw. zweite Vertiefung
- 11: quadratische Felder bzw. Lichtfenster
- 15: Ausnehmung
- 20: Platine der Bedieneinrichtung
- 21: Sensorflächen
- 22: Ausschnitte
- 23: Kontaktstift
- 30: Platine der Anzeigeeinrichtung
- 31: LED
- 32: Sieben-Segmentanzeige
- 34: Kontaktbuchse
- 40: Lack
- 41: Lücken
- 50: Bedruckung

- O: Oberseite
- U: Unterseite
- TO: Teiloberfläche
- S: Symbol

## Patentansprüche

1. Vorrichtung für ein Haushaltsgerät mit
- einem eine Oberseite (O) und eine Unterseite (U) umfassenden Trägerelement (3),
- einer wenigstens ein Bedienelement (21) aufweisenden Bedieneinrichtung (4) und
- einer wenigstens ein Anzeigeelement (31, 32) aufweisenden Anzeigeeinrichtung (5),
- wobei das Trägerelement (3) auf seiner Unterseite (U) wenigstens eine erste Aussparung (6, 8) aufweist, die als erste Vertiefung (6) auf der Unterseite (U) des Trägerelementes (3) ausgebildet ist,
- wobei die Bedieneinrichtung (4) auf der Oberseite (O) des Trägerelementes (3) und die Anzeigeeinrichtung (5) zumindest teilweise in der ersten Aussparung (6, 8) auf der Unterseite (U) des Trägerelementes (3) angeordnet ist,
- und wobei zum Erhalt der ersten Vertiefung (6) auf der Unterseite (U) des Trägerelementes (3) eine Durchgangsöffnung (8) mit einem im Wesentlichen lichtdurchlässigen Material (9) des Trägerelementes (3) verschlossen und/oder zumindest teilweise ausgefüllt ist,
**dadurch gekennzeichnet, dass** die Durchgangsöffnung (8) zur Bildung der ersten Vertiefung (6) derart mit dem im wesentlichen lichtdurchlässigen Material (9) verschlossen und/oder zumindest teilweise ausgefüllt ist, dass sich auf der Oberseite (O) des Trägerelementes (3) im Bereich der Durchgangsöffnung (8) eine im Wesentlichen plane Teiloberfläche (TO) und dass sich auf der Unterseite (U) des Trägerelementes (3) die erste Vertiefung (6) ergibt.

2. Vorrichtung nach Anspruch 1, bei der das Trägerelement (3) auf seiner Oberseite (O) wenigstens eine zweite Aussparung (10) aufweist, wobei die Bedieneinrichtung (4) zumindest teilweise in der zweiten Aussparung (10) auf der Oberseite (O) des Trägerelementes (3) angeordnet ist.

3. Vorrichtung nach Anspruch 1 oder 2, bei der das Trägerelement (3) ein im Wesentlichen lichtundurchlässiges und/oder temperaturbeständiges erstes Material (7) aufweist.

4. Vorrichtung nach einem der Ansprüche 1 bis 3, bei der das im Wesentlichen lichtdurchlässige Material (9) des Trägerelementes (3) ein zweites Material des Trägerelementes (3) ist.

5. Vorrichtung nach einem der Ansprüche 3 oder 4, bei der das erste und/oder das zweite Material ein Kunststoff ist.

6. Vorrichtung nach einem der Ansprüche 4 oder 5, bei der das zweite Material (9) ein lichtzerstreuendes Material oder ein lichtzerstreuender Kunststoff oder ein Epoxydharz ist.

7. Vorrichtung nach einem der Ansprüche 1 bis 6, bei der die Bedieneinrichtung (4) eine wenigstens ein Bedienelement (21) umfassende Platine (20) oder eine wenigstens ein Bedienelement umfassende Folie oder einen wenigstens ein Bedienelement umfassenden Bedienelementträger aufweist.

8. Vorrichtung nach Anspruch 7, bei der die Platine (20) oder die Folie oder der Bedienelementträger wenigstens eine Leiterbahn und/oder wenigstens eine Kupferfläche (21) aufweist.

9. Vorrichtung nach einem der Ansprüche 1 bis 8, bei der die Bedieneinrichtung (4) als Bedienelement wenigstens einen Sensor aufweist.

10. Vorrichtung nach Anspruch 9, bei der der Sensor ein kapazitiver Sensor oder ein kapazitiver Tastsensor ist.

11. Vorrichtung nach einem der Ansprüche 1 bis 10, bei der die Anzeigeeinrichtung (5) eine wenigstens ein Anzeigeelement (31, 32) umfassende Platine (30) oder einen wenigstens ein Anzeigeelement umfassenden Anzeigeelementträger aufweist.

12. Vorrichtung nach Anspruch 11, bei der die Platine (30) oder der Anzeigeelementträger wenigstens eine Leiterbahn aufweist.

13. Vorrichtung nach einem der Ansprüche 1 bis 12, bei der ein Anzeigeelement ein Leuchtelement oder eine LED (Light Emitting Diode) (31) oder eine Sieben-Segmentanzeige (32) ist.

14. Vorrichtung nach einem der Ansprüche 1 bis 13, bei der die Anzeigeeinrichtung (5) und die Bedieneinrichtung (4) miteinander elektrisch verbunden sind.

15. Vorrichtung nach Anspruch 14, bei der die Anzeigeeinrichtung (5) und die Bedieneinrichtung (4) über wenigstens einen Folienleiter oder wenigstens eine Kontaktbuchse (34) und wenigstens einen Kontaktstift (23) miteinander elektrisch verbunden sind.

16. Vorrichtung nach einem der Ansprüche 1 bis 15, bei der das Trägerelement (3), die Bedieneinrichtung (4) und die Anzeigeeinrichtung (5) eine Einheit (1) bilden.

17. Vorrichtung nach Anspruch 16, bei der das Trägerelement (3), die Bedieneinrichtung (4) und die Anzeigeeinrichtung (5) mittels Rastverbindung und/oder Ultraschallverschweißen und/oder Verkleben miteinander zu einer Einheit (1) verbunden sind.

18. Vorrichtung nach einem der Ansprüche 1 bis 17, bei der auf der Oberseite (O) des Trägerelementes (3) und/oder der Bedieneinrichtung (4) eine wenigstens ein Symbol aufweisende Folie angeordnet ist.

19. Vorrichtung nach einem der Ansprüche 1 bis 18, bei der die Oberfläche der Oberseite (O) des Trägerelementes (3) mit wenigstens einem Symbol bedruckt ist.

20. Vorrichtung nach Anspruch 19, bei der die Bedruckung mittels Siebdruck oder Tampondruck erfolgt.

21. Vorrichtung nach einem der Ansprüche 1 bis 20, bei der die Oberfläche der Oberseite (O) des Trägerelementes (3) zumindest teilweise beschichtet ist, wobei in die Beschichtung (40) wenigstens ein Symbol (S) eingearbeitet ist.

22. Vorrichtung nach Anspruch 21, bei der die Oberfläche mit einem lichtundurchlässigen Lack (40) versehen ist.

23. Vorrichtung nach Anspruch 21 oder 22, bei der das Symbol (S) durch teilweises Entfernen der Beschichtung (40) erhalten ist.

24. Vorrichtung nach Anspruch 23, bei der die Entfernung der Beschichtung (40) mittels eines Lasers erfolgt.

25. Vorrichtung nach einem der Ansprüche 18 bis 24, bei der ein Anzeigeelement (31) der Anzeigeeinrichtung (5) in einer ersten Vertiefung (6) des Trägerelementes (3) angeordnet ist, wobei der in Richtung auf die Oberseite (O) des Trägerelementes (3) gesehene Boden der ersten Vertiefung (6) ein im Wesentlichen lichtdurchlässiges Material (9) aufweist, wobei über dem Boden auf der Oberfläche der Oberseite (O) des Trägerelementes (3) ein Symbol (S) angeordnet ist.

26. Vorrichtung nach Anspruch 18, bei der ein Anzeigeelement (31) der Anzeigeeinrichtung (5) in einer Durchgangsöffnung (8) des Trägerelementes (3) angeordnet ist, wobei über der Durchgangsöffnung (8) auf der Oberseite (O) des Trägerelementes (3) ein Symbol auf einer Folie angeordnet ist.

27. Vorrichtung nach einem der Ansprüche 1 bis 26, welche eine Bedien- und Anzeigeeinheit (1) ist.

28. Vorrichtung nach einem der Ansprüche 1 bis 27, welche für einen Herd vorgesehen ist.

29. Vorrichtung nach Anspruch 28, welche unter einer Glaskeramik (2) eines Herdes angeordnet ist.

30. Verwendung einer Vorrichtung nach einem der Ansprüche 1 bis 26 als Bedien- und Anzeigeeinheit (1) für einen Herd.

## Claims

1. Apparatus for a domestic appliance, having
- a carrier element (3) comprising a top side (0) and a bottom side (U),
- an operator control device (4) having at least one operator control element (21), and
- a display device (5) having at least one display element (31, 32),
- wherein the carrier element (3) has, on its bottom side (U), at least one first cutout (6, 8) which is in the form of a first recess (6) on the bottom side (U) of the carrier element (3),
- wherein the operator control device (4) is arranged on the top side (0) of the carrier element (3) and the display device (5) is arranged at least partially in the first cutout (6, 8) on the bottom side (U) of the carrier element (3),
- and wherein, for the purpose of obtaining the first recess (6) on the bottom side (U) of the carrier element (3), a passage opening (8) is closed and/or at least partially filled with a substantially translucent material (9) of the carrier element (3),
**characterized in that** the passage opening (8) for forming the first recess (6) is closed and/or at least partially filled with the substantially translucent material (9) in such a way that a substantially planar subsurface (TO) is produced on the top side (0) of the carrier element (3) in the region of the passage opening (8) and that the first recess (6) is produced on the bottom side (U) of the carrier element (3).

2. Apparatus according to Claim 1, in which the carrier element (3) has at least one second cutout (10) on its top side (0), wherein the operator control device (4) is arranged at least partially in the second cutout (10) on the top side (0) of the carrier element (3).

3. Apparatus according to Claim 1 or 2, in which the carrier element (3) has a substantially opaque and/or temperature-resistant first material (7).

4. Apparatus according to one of Claims 1 to 3, in which the substantially translucent material (9) of the carrier element (3) has a second material of the carrier element (3).

5. Apparatus according to either of Claims 3 and 4, in which the first and/or the second material is a plastic.

6. Apparatus according to either of Claims 4 and 5, in which the second material (9) is a light-scattering material or a light-scattering plastic or an epoxy resin.

7. Apparatus according to one of Claims 1 to 6, in which the operator control device (4) has a printed circuit board (20) which comprises at least one operator control element (21) or has a film or foil which comprises at least one operator control element or has an operator control element carrier which comprises at least one operator control element.

8. Apparatus according to Claim 7, in which the printed circuit board (20) or the film or foil or the operator control element carrier has at least one conductor track and/or at least one copper area (21).

9. Apparatus according to one of Claims 1 to 8, in which the operator control device (4) has at least one sensor as operator control element.

10. Apparatus according to Claim 9, in which the sensor is a capacitive sensor or a capacitive touch sensor.

11. Apparatus according to one of Claims 1 to 10, in which the display device (5) has a printed circuit board (30) which comprises at least one display element (31, 32) or has a display element carrier which comprises at least one display element.

12. Apparatus according to Claim 11, in which the printed circuit board (30) or the display element carrier has at least one conductor track.

13. Apparatus according to one of Claims 1 to 12, in which a display element is a lighting element or an LED (light-emitting diode) (31) or a seven-segment display (32) .

14. Apparatus according to one of Claims 1 to 13, in which the display device (5) and the operator control device (4) are electrically connected to one another.

15. Apparatus according to Claim 14, in which the display device (5) and the operator control device (4) are electrically connected to one another by means of at least one foil conductor or at least one contact socket (34) and at least one contact pin (23).

16. Apparatus according to one of Claims 1 to 15, in which the carrier element (3), the operator control device (4) and the display device (5) form one unit (1).

17. Apparatus according to Claim 16, in which the carrier element (3), the operator control device (4) and the display device (5) are connected to one another to form one unit (1) by means of a latching connection and/or ultrasonic welding and/or adhesive bonding.

18. Apparatus according to one of Claims 1 to 17, in which a film or foil which has at least one symbol is arranged on the top side (0) of the carrier element (3) and/or of the operator control device (4).

19. Apparatus according to one of Claims 1 to 18, in which the surface of the top side (0) of the carrier element (3) is printed with at least one symbol.

20. Apparatus according to Claim 19, in which the printing is performed by means of screen printing or pad printing.

21. Apparatus according to one of Claims 1 to 20, in which the surface of the top side (0) of the carrier element (3) is at least partially coated, wherein at least one symbol (S) is incorporated into the coating (40) .

22. Apparatus according to Claim 21, in which the surface is provided with an opaque lacquer (40).

23. Apparatus according to Claim 21 or 22, in which the symbol (S) is obtained by at least partially removing the coating (40).

24. Apparatus according to Claim 23, in which the coating (40) is removed by means of a laser.

25. Apparatus according to one of Claims 18 to 24, in which a display element (31) of the display device (5) is arranged in a first recess (6) of the carrier element (3), wherein the base of the first recess (6) as seen in the direction onto the top side (0) of the carrier element (3) has a substantially translucent material (9), wherein a symbol (S) is arranged above the base on the surface of the top side (0) of the carrier element (3).

26. Apparatus according to Claim 18, in which a display element (31) of the display device (5) is arranged in a passage opening (8) of the carrier element (3), wherein a symbol is arranged on a film or foil above the passage opening (8) on the top side (0) of the carrier element (3).

27. Apparatus according to one of Claims 1 to 26, which is an operator control and display unit (1).

28. Apparatus according to one of Claims 1 to 27, which is provided for a cooker.

29. Apparatus according to Claim 28, which is arranged beneath a glass ceramic (2) of a cooker.

30. Use of an apparatus according to one of Claims 1 to 26 as an operator control and display unit (1) for a cooker.

## Revendications

1. Dispositif pour un appareil ménager doté
- d'un élément porteur (3) comprenant une face supérieure (0) et une face inférieure (U),
- d'un dispositif de commande (4) comportant un minimum d'un élément de commande (21) et
- d'un dispositif d'indication (5) comportant un minimum d'un élément d'indication (31, 32),
- dans lequel l'élément porteur (3) comporte sur sa face inférieure (U) un minimum d'une première cavité (6, 8), laquelle est conçue comme première encoche (6) sur la face inférieure (U) de l'élément porteur (3),
- dans lequel le dispositif de commande (4) est agencé sur la face supérieure (0) de l'élément porteur (3) et le dispositif d'indication (5) est agencé au moins partiellement dans la première cavité (6,8) sur la face inférieure (U) de l'élément porteur (3),
- et dans lequel une ouverture de passage (8) est fermée et/ou au moins partiellement remplie par un matériau essentiellement translucide (9) de l'élément porteur (3) pour recevoir la première encoche (6) sur la face inférieure (U) de l'élément porteur (3),
**caractérisé en ce que** l'ouverture de passage (8), pour former la première encoche (6), est fermée et/ou au moins partiellement remplie par le matériau essentiellement translucide (9) de telle sorte qu'une surface supérieure partielle (TO) essentiellement plane apparaît sur la face supérieure (0) de l'élément porteur (3) dans la zone de l'ouverture de passage (8) et que la première encoche (6) apparaît sur la face inférieure (U) de l'élément porteur (3).

2. Dispositif selon la revendication 1, où l'élément porteur (3) comporte sur sa face supérieure (0) un minimum d'une seconde cavité (10), dans lequel le dispositif de commande (4) est agencé au moins partiellement dans la seconde cavité (10) sur la face supérieure (0) de l'élément porteur (3).

3. Dispositif selon la revendication 1 ou 2, où l'élément porteur (3) comporte un premier matériau (7) essentiellement translucide et/ou thermorésistant.

4. Dispositif selon l'une des revendications 1 à 3, où le matériau essentiellement translucide (9) de l'élément porteur (3) est un second matériau de l'élément porteur (3).

5. Dispositif selon l'une des revendications 3 ou 4, où le premier et/ou le second matériau est un plastique.

6. Dispositif selon l'une des revendications 4 ou 5, où le second matériau (9) est un matériau diffuseur de lumière ou un plastique diffuseur de lumière ou une résine époxy.

7. Dispositif selon l'une des revendications 1 à 6, où le dispositif de commande (4) comporte un circuit imprimé (20) comprenant un minimum d'un élément de commande (21) ou un film comprenant un minimum d'un élément de commande ou un porteur d'élément de commande comprenant un minimum d'un élément de commande.

8. Dispositif selon la revendication 7, où le circuit imprimé (20) ou le film ou le porteur d'élément de commande comporte un minimum d'une piste conductrice et/ou un minimum d'une surface de cuivre (21).

9. Dispositif selon l'une des revendications 1 à 8, où le dispositif de commande (4) comporte un minimum d'un capteur comme élément de commande.

10. Dispositif selon la revendication 9, où le capteur est un capteur capacitif ou un capteur capacitif tactile.

11. Dispositif selon l'une des revendications 1 à 10, où le dispositif d'indication (5) comporte un circuit imprimé (30) comprenant un minimum d'un élément d'indication (31, 32) ou un porteur d'élément d'indication comprenant un minimum d'un élément d'indication.

12. Dispositif selon la revendication 11, où le circuit imprimé (30) ou le porteur d'élément d'indication comporte un minimum d'une piste conductrice.

13. Dispositif selon l'une des revendications 1 à 12, où un élément d'indication est un élément lumineux ou une LED (Light Emitting Diode) (31) ou un affichage à sept segments (32).

14. Dispositif selon l'une des revendications 1 à 13, où le dispositif d'indication (5) et le dispositif de commande (4) sont raccordés électriquement l'un à l'autre.

15. Dispositif selon la revendication 14, où le dispositif d'indication (5) et le dispositif de commande (4) sont raccordés électriquement l'un à l'autre au moyen d'un minimum d'un conducteur plat ou un minimum d'une douille de contact (34) et un minimum d'une broche de contact (23).

16. Dispositif selon l'une des revendications 1 à 15, où l'élement porteur (3), le dispositif de commande (4) et le dispositif d'indication (5) forment une unité (1).

17. Dispositif selon la revendication 16, où l'élément porteur (3), le dispositif de commande (4) et le dispositif d'indication (5) sont raccordés l'un à l'autre par une liaison d'encliquetage et/ou par soudure aux ultrasons et/ou par collage pour former une unité (1).

18. Dispositif selon l'une des revendications 1 à 17, où un film comportant un minimum d'un symbole est agencé sur la face supérieure (0) de l'élément porteur (3) et/ou le dispositif de commande (4).

19. Dispositif selon l'une des revendications 1 à 18, où un minimum d'un symbole est imprimé sur la surface externe de la face supérieure (0) de l'élément porteur (3).

20. Dispositif selon la revendication 19, où l'impression est exécutée par sérigraphie ou tampographie.

21. Dispositif selon l'une des revendications 1 à 20, où la surface externe de la face supérieure (0) de l'élément porteur (3) est revêtue au moins partiellement, dans lequel un minimum d'un symbole (S) est intégré dans le revêtement (40).

22. Dispositif selon la revendication 21, où la surface externe est prévue avec un vernis translucide (40).

23. Dispositif selon la revendication 21 ou 22, où le symbole (S) est conservé par enlèvement du revêtement (40).

24. Dispositif selon la revendication 23, où l'enlèvement du revêtement (40) est exécuté par laser.

25. Dispositif selon l'une des revendications 18 à 24, où un élément d'indication (31) du dispositif d'indication (5) est agencé dans une première encoche (6) de l'élément porteur (3), dans lequel le fond de la première encoche (6) (visible dans la direction de la face supérieure (0) de l'élément porteur (3)) comporte un matériau essentiellement translucide (9), dans lequel un symbole (S) est agencé au-dessus du fond sur la surface externe de la face supérieure (0) de l'élément porteur (3).

26. Dispositif selon la revendication 18, où un élément d'indication (31) du dispositif d'indication (5) est agencé dans une ouverture de passage (8) de l'élément porteur (3), dans lequel un symbole est agencé sur un film au-dessus de l'ouverture de passage (8) sur la face supérieure (0) de l'élément porteur (3).

27. Dispositif selon l'une des revendications 1 à 26, lequel est une unité de commande et d'indication (1).

28. Dispositif selon l'une des revendications 1 à 27, lequel est prévu pour une cuisinière.

29. Dispositif selon la revendication 28, lequel est agencé sous une vitrocéramique (2) d'une cuisinière.

30. Application d'un dispositif selon l'une des revendications 1 à 26, comme unité de commande et d'indication (1) pour une cuisinière.
